(19) **Europäisches Patentamt / European Patent Office / Office européen des brevets**

(11) **EP 2 494 693 B1**

(12) **FASCICULE DE BREVET EUROPEEN**

(45) Date de publication et mention de la délivrance du brevet:
**13.11.2013 Bulletin 2013/46**

(21) Numéro de dépôt: **10771449.5**

(22) Date de dépôt: **28.10.2010**

(51) Int Cl.:
*H03L 7/07* (2006.01)   *H03L 7/087* (2006.01)
*H03L 7/091* (2006.01)

(86) Numéro de dépôt international:
**PCT/EP2010/066405**

(87) Numéro de publication internationale:
**WO 2011/051407 (05.05.2011 Gazette 2011/18)**

(54) **DISPOSITIF DE GENERATION DE SIGNAUX D'HORLOGE A COMPARAISON ASYMETRIQUE D'ERREURS DE PHASE**

VORRICHTUNG ZUR ERZEUGUNG VON TAKTSIGNALEN FÜR DEN ASYMMETRISCHEN VERGLEICH VON PHASENFEHLERN

DEVICE FOR GENERATING CLOCK SIGNALS FOR ASYMMETRIC COMPARISON OF PHASE ERRORS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **29.10.2009 FR 0957638**

(43) Date de publication de la demande:
**05.09.2012 Bulletin 2012/36**

(73) Titulaires:
• **Commissariat à l'Énergie Atomique et aux Énergies Alternatives**
  **75015 Paris (FR)**
• **Centre National de la Recherche Scientifique**
  **75016 Paris (FR)**
• **L'Université Pierre et Marie Curie - (Paris 6)**
  **75252 Paris Cedex 05 (FR)**

(72) Inventeurs:
• **COLINET, Eric**
  **F-38240 Meylan (FR)**
• **GALAYKO, Dimitri**
  **F-75011 Paris (FR)**
• **KORNIIENKO, Anton**
  **F-38000 Grenoble (FR)**

(74) Mandataire: **Ilgart, Jean-Christophe et al**
  **BREVALEX**
  **95 rue d'Amsterdam**
  **75378 Paris Cedex 8 (FR)**

(56) Documents cités:
| | |
|---|---|
| WO-A1-92/13305 | US-A- 3 504 125 |
| US-A- 3 597 552 | US-A- 3 920 915 |
| US-A1- 2005 141 662 | US-B1- 6 633 621 |

• COLINET E ET AL: "Hâ loop shaping control for distributed PLL network", RESEARCH IN MICROELECTRONICS AND ELECTRONICS, 2009. PRIME 2009. PH.D, IEEE, PISCATAWAY, NJ, USA, 12 juillet 2009 (2009-07-12), pages 336-339, XP031510386, ISBN: 978-1-4244-3733-7
• VADIM GUTNIK ET AL: "Active GHz Clock Network Using Distributed PLLs", IEEE JOURNAL OF SOLID-STATE CIRCUITS, IEEE SERVICE CENTER, PISCATAWAY, NJ, USA, vol. 35, no. 11, 1 novembre 2000 (2000-11-01), XP011061364, ISSN: 0018-9200

**Description**

**DOMAINE TECHNIQUE**

L'invention concerne le domaine de la génération et de la synchronisation de signaux d'horloges distribués, utilisés par exemple pour la synchronisation d'un ou plusieurs dispositifs tels que des microprocesseurs, et/ou dans le domaine des télécommunications.

**ÉTAT DE LA TECHNIQUE ANTÉRIEURE**

Dans un système numérique synchrone, un signal d'horloge permet de définir une référence de temps servant notamment à la propagation des données dans le système et au cadencement des différents éléments du système. Un système synchrone sur puce, par exemple un microprocesseur, comporte généralement un arbre de distribution d'horloges permettant de distribuer les signaux d'horloge depuis une source jusqu'aux éléments séquentiels du système à cadencer. La synchronisation des horloges générées est obtenue en égalisant les délais de propagation du signal d'horloge provenant de la source dans chaque branche du système de distribution.

Pour les circuits de systèmes à multiprocesseurs, il est très compliqué, et parfois impossible, de réaliser un arbre de distribution d'horloges parfaitement équilibré. Cet équilibrage est  souvent imprécis et une désynchronisation des signaux d'horloge peut apparaitre dans ces circuits. De plus, lorsqu'un nouvel élément est ajouté au système, par exemple un microprocesseur supplémentaire, cela peut nécessiter de redimensionner la totalité de l'arbre de distribution d'horloges. Enfin, un défaut dans une des branches de l'arbre de distribution d'horloges peut facilement affecter une grande partie du système parallèle dépendant de l'emplacement de la défaillance.

Par ailleurs, même lorsque l'arbre de distribution d'horloges est bien conçu et équilibré, en respectant toutes les longueurs de branches sans défaillance, il existe toujours d'importantes sources d'imperfections du type « skew » (déphasage par rapport à la valeur nominale de l'horloge) et « jitter » (oscillations autour de la valeur nominale de l'horloge) qui sont liées notamment à l'utilisation de buffers dans l'arbre de distribution de signaux d'horloge, servant de répéteurs du signal d'horloge, et à la diaphonie entre les lignes. Ces imperfections sont particulièrement critiques pour des signaux d'horloge de fréquences élevées. De plus, en raison de l'augmentation des fréquences des signaux d'horloge, il peut arriver que le « skew » d'horloge à travers la puce soit comparable au cycle d'horloge, provoquant inévitablement des erreurs de calcul. Enfin, l'utilisation d'une fréquence d'horloge élevée implique une consommation de puissance importante (dissipée en partie sous forme de chaleur). Cette surconsommation est causée notamment par la forte impédance parasite  des larges branches de distribution nécessaires dans un arbre de distribution de signaux d'horloge.

En alternative à l'arbre classique de distribution de signaux d'horloge, il est possible d'utiliser un réseau distribué de PLL (boucles à verrouillage de phase, ou boucles à phase asservie) aux entrées multiples, interconnectées, ou couplées, entre elles, chaque PLL générant un signal d'horloge local synchronisé de manière active avec les autres PLL. De manière générale, une PLL est composée d'un ou plusieurs comparateurs de phases (également appelé détecteur de phases), d'un VCO (oscillateur commandé en tension) et d'un correcteur assurant le contrôle du VCO pour se synchroniser par rapport à un signal d'horloge de référence. On dit qu'un ensemble d'oscillateurs est synchronisé en termes de phase et de fréquence lorsque chacun des oscillateurs oscille sur une même fréquence avec une même phase. La synchronisation est qualifiée d'active lorsque la mesure et la compensation du déphasage se font en temps réel, ce qui permet, à chaque instant, de remédier aux problèmes liés à l'influence de toutes les perturbations possibles (température, impédance parasite, dispersion, vieillissement, défaillance).

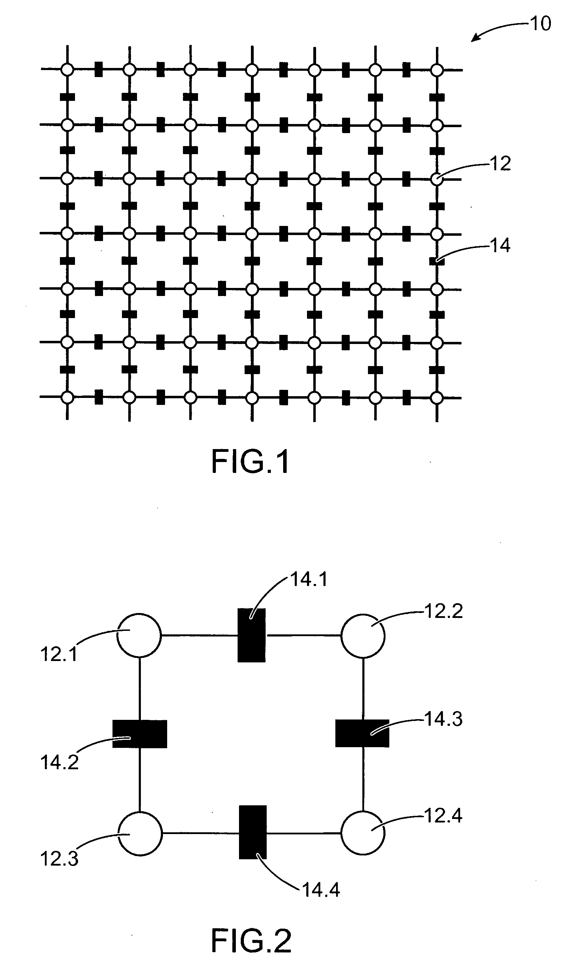

Un exemple d'un tel réseau distribué 10 de PLL est représenté sur la figure 1. Ce réseau 10 possède des noeuds 12, chaque noeud 12 comportant un VCO, un additionneur et un correcteur fournissant au VCO la commande réglant la fréquence du VCO. Un ou plusieurs des noeuds 12 du réseau distribué 10 ne sont pas formés par un VCO et son correcteur-associé mais par une ou plusieurs sources oscillantes synchrones formant une horloge maître sur laquelle vont se synchroniser les oscillateurs formés par les autres noeuds du réseau distribué 10. Les noeuds 12 forment des générateurs d'horloge séparés spatialement les uns des autres et reliés entre eux sous la forme d'une grille régulière en deux dimensions. Des comparateurs de phases 14 disposés entre les noeuds 12 fournissent l'erreur de phase d'un VCO par rapport au VCO voisin. Chaque VCO des noeuds 12 forme, avec les comparateurs de phases 14 qui lui sont adjacents, une PLL. Les erreurs de phase provenant des noeuds voisins de chacun des noeuds 12 sont additionnées et filtrées à l'intérieur de ce noeud et sont utilisées pour ajuster la phase du VCO de ce noeud afin de la rendre égale à la phase moyenne des noeuds voisins. Ainsi, lorsque chaque noeud est synchronisé avec la phase moyenne de ses noeuds voisins, l'ensemble du réseau distribué 10 est censé être globalement synchronisé en fréquence et en phase. Les horloges locales synchrones formées au niveau de chaque noeud 12 peuvent ensuite être facilement distribuées à l'aide des méthodes classiques simples au vue de la petite taille des zones locales, résolvant ainsi les problèmes rencontrés avec les arbres de distribution de signaux d'horloge.

Dans cette architecture, au lieu d'utiliser de larges branches de distribution, on n'utilise donc que de simples lignes permettant l'interconnexion des noeuds voisins, compensant ainsi de manière systématique les délais de propagation. De plus, en utilisant des diviseurs de fréquence à l'intérieur de chaque noeud, il est possible de distribuer le signal d'horloge en basse fréquence tout en gardant des fréquences locales (au niveau des noeuds) élevées.

Une telle architecture de réseau distribué de PLL présente toutefois un défaut majeur. En effet, en raison de la nature cyclique de la phase (par exemple: $\pi/2 = -3\pi/2 = 5\pi/2$), il est possible que le réseau 10 se stabilise dans des modes dans lesquels on a bien une erreur moyenne de phases nulle dans chaque noeud du réseau (moyenne des erreurs de phase délivrées par les comparateurs de phases adjacents à chaque noeud), mais dans lesquels plusieurs horloges ne sont pas synchronisées en phase. Ces modes, appelés modes parasites ou « mode-locking », sont des points d'équilibre stables caractérisés par une fréquence égale dans chaque noeud et avec des déphasages constants. Un tel mode parasite est illustré pour un réseau de 2x2 noeuds interconnectés représenté sur la figure 2. Les fréquences d'oscillation des VCO des 4 noeuds 12.1 - 12.4 sont identiques. A un instant t, la phase au niveau du noeud 12.1 est égale à 0, celle au niveau du noeud 12.2 est égale à n/2, celle au niveau du noeud 12.3 est égale à -n/2 et celle au niveau du noeud 12.4 est égale à n. Dans cette configuration, pour chacun des noeuds 12.1 - 12.4, l'erreur de phase d'un noeud voisin est exactement annulée par l'erreur de phase de l'autre noeud voisin (les erreurs de phase étant envoyées entre les noeuds 12.1 - 12.4 par des comparateurs de phases 14.1 - 14.4, chaque comparateur fonctionnant de manière bidirectionnelle pour les deux noeuds qui lui sont adjacents). L'erreur totale de phases pour les quatre noeuds 12.1 - 12.4 est donc nulle malgré l'inégalité des phases entre chaque noeud du réseau. Un tel réseau se retrouve donc maintenu dans un mode parasite stable (régime de mode-locking).

Le document WO 92/13305 décrit une solution pour résoudre le problème des modes parasites dans un réseau d'oscillateurs distribués. Cette solution consiste à utiliser des comparateurs de phases particuliers. Il est notamment démontré dans ce document que lorsqu'un tel réseau se stabilise dans un mode parasite, au moins un des comparateurs de phases mesure un déphasage $\Delta\varphi \geq n/2$. Il est donc proposer de réaliser des comparateurs de phases présentant une réponse statique particulière comportant notamment une pente négative lorsque $\Delta\varphi \geq n/2$, rendant le réseau instable lorsque celui-ci se trouve dans un mode parasite.

Toutefois, l'implémentation de tels comparateurs de phases est très délicate et est la cause de problèmes lorsque l'on souhaite assurer avec certitude la stabilité du système de distribution d'horloges sous différentes conditions de fonctionnement (tension, température, bruit). Par ailleurs, la réalisation pratique de ces comparateurs de phases ne fait appel qu'à des composants analogiques, ne faisant qu'aggraver les problèmes mentionnés ci-dessus. Les systèmes sur puce actuels sont perturbés par de nombreuses sources de bruits électriques pouvant affecter les signaux de contrôle. Le filtre correcteur associé à chaque noeud du réseau doit donc éliminer suffisamment de bruit tout en limitant la surface de silicium nécessaire à son déploiement pour des questions de coût. Ces contraintes rendent encore plus difficile l'analyse de la stabilité du système de distribution d'horloges.

Un exemple de génération d'horloge est décrit par la publication COLINET E ET AL: "H∞ loop shaping control for distributed PLL network", RESEARCH IN MICROELECTRONICS AND ELECTRONICS, 2009. PRIME 2009. PH.D, IEEE, PISCATAWAY, NJ, USA, 12 juillet 2009 (2009-07-12), pages 336-339, ISBN: 978-1-4244-3733-7. Un tel dispositif de génération d'au moins un signal d'horloge, comporte un réseau distribué de boucles à phase asservie interconnectées et synchronisées les unes aux autres, chaque boucle à phase asservie comprenant:

- un oscillateur commandé apte à délivrer en sortie le signal d'horloge,

- une pluralité de comparateurs de phases aptes à comparer une phase du signal d'horloge délivré par l'oscillateur commandé avec une pluralité de phases de signaux d'horloge délivrés en sorties des boucles à phase asservie voisines et appliqués en entrées de la boucle à phase asservie,

- des moyens de sommation pondérée de signaux de sortie de la pluralité de comparateurs de phases,

- des moyens de filtrage de la somme pondérée des signaux de sortie de la pluralité de comparateurs de phases, aptes à délivrer en sortie un signal de commande à l'oscillateur commandé.

EXPOSÉ DE L'INVENTION

Un but de la présente invention est de proposer un dispositif de génération d'au moins un signal d'horloge évitant les modes parasites (mode-locking), c'est-à-dire réduisant le risque de stabilisation du dispositif dans un mode parasite, et qui n'implique pas une implémentation complexe de comparateurs de phases.

Il est proposé un dispositif de génération d'au moins un signal d'horloge, comportant au moins une boucle à phase asservie comprenant :

- un oscillateur commandé apte à délivrer en sortie le signal d'horloge,
- une pluralité de comparateurs de phases aptes à comparer une phase du signal d'horloge délivré par l'oscillateur commandé avec une pluralité de phases de signaux d'horloge appliqués en entrée de la boucle à phase asservie,

- des moyens de sommation pondérée de signaux de sortie de la pluralité de comparateurs de phases tels qu'au moins un des coefficients de pondération appliqué à un desdits signaux de sortie ait une valeur absolue supérieure aux valeurs absolues des autres coefficients de pondération appliqués aux autres signaux de sortie,
- des moyens de filtrage de la somme pondérée des signaux de sortie de la pluralité de comparateurs de phases aptes à délivrer en sortie un signal de commande à l'oscillateur commandé.

Il est également proposé un dispositif de génération d'au moins un signal d'horloge, comportant un réseau distribué de boucles à phase asservie interconnectées et synchronisées les unes aux autres, chaque boucle à phase asservie comprenant :

- un oscillateur commandé apte à délivrer en sortie le signal d'horloge,
- une pluralité de comparateurs de phases aptes à comparer une phase du signal d'horloge délivré par l'oscillateur commandé avec une pluralité de phases de signaux d'horloge délivrés en sorties des boucles à phase asservie voisines et appliqués en entrées de la boucle à phase asservie,
- des moyens de sommation pondérée de signaux de sortie de la pluralité de comparateurs de phases tels qu'un des coefficients de pondération appliqué à un desdits signaux de sortie ait une valeur absolue supérieure à la somme des valeurs absolues des autres coefficients de pondération appliqués aux autres signaux de sortie et/ou tels que la somme des valeurs absolues des coefficients de pondération appliqués à une partie desdits signaux de sortie soit supérieure à la somme des valeurs absolues des autres coefficients de pondération appliqués aux autres signaux de sortie,
- des moyens de filtrage de la somme pondérée des signaux de sortie de la pluralité de comparateurs de phases, aptes à délivrer en sortie un signal de commande à l'oscillateur commandé,

et dans lequel, lorsque la somme des valeurs absolues des coefficients de pondération appliqués à une partie desdits signaux de sortie est supérieure à la somme des valeurs absolues des autres coefficients de pondération appliqués aux autres signaux de sortie, les signaux d'horloge, délivrés en sorties des boucles à phase asservie voisines et dont les phases comparées à la phase du signal d'horloge délivré par l'oscillateur commandé correspondent auxdits signaux de sortie auxquels sont appliqués les coefficients de pondération dont la somme des valeurs absolues est supérieure à la somme des valeurs absolues des autres coefficients de pondération, se propagent dans le réseau distribué de boucles à phase asservie sans former de boucle fermée.

Ce dispositif, grâce à la sommation pondérée réalisée entre les signaux de sortie des comparateurs de phases, réalise donc une comparaison asymétrique entre les différentes erreurs de phase des signaux d'horloge appliqués en entrée de la PLL, par exemple issus de noeuds voisins lorsque ce dispositif forme un réseau distribué de PLL. Cette comparaison asymétrique permet au dispositif de fonctionner selon deux modes différents. En effet, lorsque la phase du signal d'horloge généré par l'oscillateur commandé est éloignée des phases des signaux d'horloge appliqués en entrée de la PLL, l'ensemble des différences de phases entre le signal d'horloge généré par l'oscillateur commandé et les signaux d'horloge appliqués en entrée de la PLL sont prises en compte. Par contre, lorsque la phase du signal d'horloge généré par l'oscillateur commandé est proche des phases des signaux d'horloge appliqués en entrée de la PLL, par exemple comprise entre les phases de deux de ces signaux d'horloge, la pondération réalisée lors de la sommation des erreurs de phase permet de ne prendre en compte que l'erreur de phase pondérée par le plus fort coefficient, et donc de privilégier au moins une des erreurs de phase par rapport aux autres erreurs de phase (ou par exemple privilégier deux des erreurs de phase par rapport à au moins deux autres erreurs de phase).

Le changement de l'un à l'autre des modes de fonctionnement se passe de manière automatique et simple. Cela permet, lorsque le dispositif forme un réseau distribué de PLL, d'utiliser les informations provenant de toutes les PLL voisines lorsque le réseau travaille dans un mode éloigné des modes parasites, et de les éviter en ignorant certaines erreurs de phase dans le cas où l'on est trop proche de ces modes.

Le dispositif est particulièrement avantageux lorsqu'il est destiné à générer au moins trois signaux d'horloge, c'est-à-dire trois signaux périodiques interconnectés.

Le dispositif peut notamment former un système non-linéaire comportant un seul mode stable grâce à l'élimination des modes parasites.

De plus, un tel dispositif a notamment pour avantage, par rapport aux réseaux distribués de PLL de l'art antérieur, de réaliser rapidement la synchronisation en fréquence et en phase des signaux d'horloge.

Dans chaque boucle à phase asservie, un des coefficients de pondération appliqué à un des signaux de sortie peut avoir une valeur absolue supérieure à la somme des valeurs absolues des autres coefficients de pondération appliqués aux autres signaux de sortie. On améliore ainsi la résolution des problèmes liés aux modes-locking, évitant au dispositif de se stabiliser dans une partie de ces modes parasites.

Il est également possible que la somme des valeurs absolues des coefficients de pondération appliqués à une partie desdits signaux de sortie soit supérieure à la somme des valeurs absolues des autres coefficients de pondération appliqués aux autres signaux de sortie. Ces coefficients sont alors choisis, pour l'ensemble des boucles à phase asservie du réseau, tels que les signaux d'horloge, délivrés en sorties des boucles à phase asservie voisines et dont les phases comparées à la phase du signal d'horloge délivré par l'oscillateur commandé correspondent auxdits signaux de sortie auxquels sont appliqués les coefficients de pondération dont la somme des valeurs absolues est supérieure à la somme des valeurs absolues des autres coefficients de pondération, se propagent dans le réseau distribué de boucles à phase asservie sans former de boucle fermée, afin d'éviter une stabilisation du dispositif dans un mode parasite.

Chaque boucle à phase asservie peut comporter deux, trois ou quatre comparateurs de phases aptes à comparer une phase du signal d'horloge délivré par l'oscillateur commandé avec les phases des signaux d'horloge appliqués en entrée de la boucle à phase asservie. Lorsque le dispositif forme un réseau distribué de PLL en forme de grille en deux dimensions, la PLL peut comporter deux comparateurs de phases lorsqu'elle forme un coin du réseau, trois comparateurs de phases lorsque la PLL est disposée au niveau d'un bord du réseau, et quatre comparateurs de phases lorsque la PLL est disposée entre les bords du réseau.

Chaque comparateur de phases peut être apte à délivrer en sortie un signal codé sur 1 bit représentatif du signe de la comparaison destinée à être réalisée par le comparateur de phases entre la phase du signal d'horloge délivré par l'oscillateur commandé et la phase d'un des signaux d'horloge appliqués en entrée de la boucle à phase asservie.

L'utilisation de tels comparateurs de phases permet de garantir que le dispositif ne se stabilise jamais dans un des modes parasites (mode-locking), quelques soient les conditions initiales de fonctionnement du dispositif.

Les comparateurs de phases peuvent être du type bang-bang. De tels comparateurs de phases ont notamment pour avantage d'être simples à implémenter. Il est toutefois possible d'utiliser n'importe quel type de comparateur de phases, notamment des comparateurs de phases présentant une saturation dans leurs réponses de sortie.

Dans une variante, chaque comparateur de phases peut être apte à délivrer en sortie un signal codé sur plusieurs bits représentant le signe et la valeur absolue de la comparaison destinée à être réalisée par le comparateur de phases entre la phase du signal d'horloge délivré par l'oscillateur commandé et la phase d'un des signaux d'horloge appliqués en entrée de la boucle à phase asservie. Dans ce cas, on code non seulement le signe de l'erreur de phases mais également sa valeur absolue.

Dans ce cas, la valeur absolue $n_j$ dudit un des coefficients de pondération appliqué à un desdits signaux de sortie qui est supérieure à la somme des valeurs absolues ni des autres coefficients de pondération appliqués aux autres signaux de sortie est telle que :

$$n_j > \frac{K}{k} \sum_{i \neq j} n_i \, ,$$

avec

K : valeur maximale de la valeur absolue de la sortie d'un des comparateurs de phases ;
k : valeur minimale de la valeur absolue de la sortie d'un des comparateurs de phases.

Dans une autre variante, lorsque la somme des valeurs absolues $n_j$ des coefficients de pondération appliqués à une partie desdits signaux de sortie est supérieure à la somme des valeurs absolues ni des autres coefficients de pondération appliqués aux autres signaux de sortie, les valeurs absolues $n_j$ sont telles que :

$$\sum n_j > \frac{K}{k} \sum_{i \neq j} n_i \, ,$$

avec

K : valeur maximale de la valeur absolue de la sortie d'un des comparateurs de phases ;
k : valeur minimale de la valeur absolue de la sortie d'un des comparateurs de phases.

Les moyens de filtrage peuvent comporter au moins un filtre passe-bas. Un tel filtre passe-bas permet notamment de supprimer les bruits hautes-fréquences du signal correspondant à la somme pondérée des signaux de sortie des comparateurs de phases et, lorsque le dispositif est du type analogique, c'est-à-dire comportant une PLL réalisée par des éléments électroniques analogiques, de filtrer des harmoniques hautes-fréquences du signal correspondant à la somme pondérée des signaux de sortie des comparateurs de phases.

Les coefficients de pondération des moyens de sommation pondérée peuvent avoir chacun une valeur comprise entre -3 et 3.

Toutefois, de manière générale, et notamment lorsque le réseau distribué de boucles à phase asservie forme un réseau en deux dimensions, les coefficients de pondération des moyens de sommation pondérée peuvent avoir chacun une valeur comprise entre -4K/k et 4K/k. Dans le cas où k = 1 et lorsque chaque comparateur de phases délivre en sortie un signal codé sur 1 bit, on a alors K = k = 1, les coefficients de pondération des moyens de sommation pondérée pouvant avoir chacun une valeur comprise entre -4 et 4. La plage de valeurs des coefficients de pondération des moyens de sommation pondérée peut également être supérieure à la plage de valeurs [-4 ; 4], par exemple lorsque les comparateurs de phases délivrent en sortie des signaux codés sur plusieurs bits et que la valeur maximale de la valeur absolue de la sortie d'un des comparateurs de phases est supérieure à 1.

Ladite valeur absolue supérieure aux autres valeurs absolues peut être supérieure à la somme desdites autres valeurs absolues.

L'oscillateur commandé et/ou les comparateurs de phases et/ou les moyens de sommation pondérée et/ou les moyens de filtrage peuvent être de type numérique. Toutefois, il est, également possible que ces éléments, ou plus généralement l'ensemble du dispositif de génération de signal d'horloge, soient réalisés de manière analogique.

Le dispositif peut comporter une pluralité de boucles à phase asservie similaires à ladite boucle à phase asservie et reliées entre elles sous la forme d'une grille, les signaux d'horloge appliqués en entrée des boucles à phase asservie pouvant être les signaux d'horloge délivrés en sortie des boucles à phase asservie voisines.

Le dispositif peut comporter en outre au moins un générateur d'un signal d'horloge de référence appliqué en entrée d'au moins une de la pluralité de boucles à phase asservie.

L'invention concerne également un dispositif électronique comportant une pluralité d'éléments électroniques synchronisés par des signaux d'horloge synchrones délivrés par les boucles à verrouillage de phase d'un dispositif tel que décrit précédemment. Un tel dispositif électronique peut être par exemple un microprocesseur ou un système multiprocesseur.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

- la figure 1 représente un réseau distribué de PLL interconnectées générant des signaux d'horloge,
- la figure 2 représente un réseau distribué de quatre noeuds de PLL interconnectées générant des signaux d'horloge,
- la figure 3 représente schématiquement un dispositif de génération de signaux d'horloge, objet de la présente invention, selon un mode de réalisation particulier,
- la figure 4 représente le schéma d'une PLL d'un dispositif de génération de signaux d'horloge, objet de la présente invention, selon un mode de réalisation particulier,
- la figure 5 représente la réponse d'un comparateur de phases de type bang-bang d'une PLL d'un dispositif de génération de signaux d'horloge, objet de la présente invention,
- la figure 6 représente un exemple de réalisation d'un comparateur de phases de type bang-bang d'une PLL d'un dispositif de génération de signaux d'horloge, objet de la présente invention,
- la figure 7 représente un exemple de réalisation d'une PLL d'un dispositif de génération de signaux d'horloge, objet de la présente invention,
- la figure 8 représente la synchronisation de phases réalisée par la PLL représentée sur la figure 7,
- la figure 9 représente un exemple de réalisation d'une PLL ne réalisant pas une comparaison asymétrique des erreurs de phase appliquées en entrée de la PLL,
- la figure 10 représente le comportement dynamique de la PLL de la figure 9 sans la synchronisation de phases,
- les figures 11A, 11B et 11C représentent des résultats de simulations de trois PLL d'un dispositif de génération de signaux d'horloge, objet de la présente invention, et d'un signal de référence extérieur,
- la figure 12 représente une partie d'un dispositif de génération de signaux d'horloge, objet de la présente invention, selon un mode de réalisation particulier, dans lequel des signaux d'horloge se propagent dans le réseau distribué de boucles à phase asservie sans former de boucle fermée.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

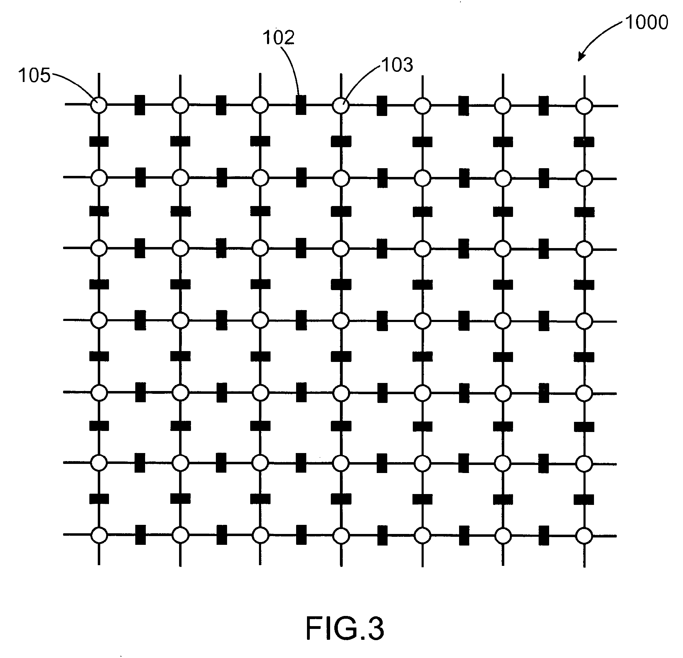

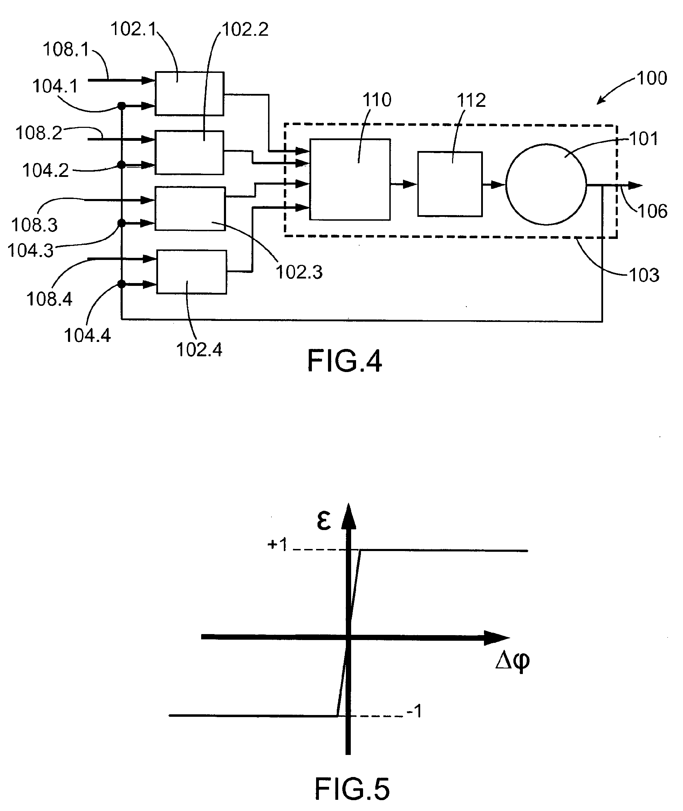

On se réfère tout d'abord à la figure 3 qui représente un dispositif 1000 de génération de signaux d'horloge selon un mode de réalisation particulier. De manière analogue au réseau distribué 10 représenté sur la figure 1, le dispositif 1000 forme un réseau distribué de boucles à phase asservie, ou PLL, interconnectées et synchronisées les unes aux autres. Ce réseau forme ici une grille en deux dimensions. Chacune des PLL est formée par un noeud 103 de la grille composé d'un oscillateur commandé, de moyens de sommation pondérée et des moyens de filtrage qui seront détaillés plus loin en liaison avec la PLL 100 représentée sur la figure 4. Chacune des PLL est également formée des comparateurs de phases 102 disposés entre chaque noeud 103. Chacun de ces comparateurs de phases 102 sert à former deux PLL à partir des deux noeuds 103 adjacents à chacun des comparateurs de phases 102. Un tel dispositif 1000 permet de générer, au niveau de chaque noeud 103, un signal d'horloge synchronisé aux autres signaux d'horloge délivrés au niveau des autres noeuds 103. Dans ce mode de réalisation particulier, au moins un des noeuds 103 du dispositif 1000 ne forme pas une PLL mais sert à générer un signal d'horloge de référence auquel les PLL du dispositif 1000 se synchroniseront en fréquence et en phase. Par exemple, sur l'exemple de la figure 3, c'est le noeud référencé 105 qui comporte un tel générateur, formant une horloge maître du dispositif 1000. Toutefois, dans une variante de ce mode de réalisation, il est possible que tous les noeuds 103 du dispositif 1000 forment des PLL, le dispositif 1000 n'utilisant alors pas d'horloge maître pour synchroniser le réseau de PLL. Dans cette variante, les oscillateurs du dispositif 1000 se synchronisent en fréquence et en phase entre eux, sans horloge extérieure, la fréquence obtenue pouvant correspondre à une fréquence moyennée, dont la valeur dépend des coefficients choisis, d'un signal pouvant être interprété comme un signal maître virtuel moyenné.

On voit sur la figure 3 que les PLL sont interconnectées entre elles de manière bidirectionnelle et forment plusieurs boucles fermées de PLL.

On se réfère maintenant à la figure 4 qui représente une PLL 100 du dispositif de génération de signaux d'horloge 1000. Cette PLL 100 comporte un oscillateur 101, ici un DCO (oscillateur commandé numérique), c'est-à-dire un VCO (oscillateur commandé en tension) apte à recevoir un signal de commande numérique sur 1 ou plusieurs bits. La PLL 100 comporte également plusieurs comparateurs de phases, ici quatre comparateurs de phases 102.1 - 102.4, chacun de ces comparateurs de phases étant apte à réaliser une comparaison entre la phase du signal d'horloge délivré par l'oscillateur local, c'est-à-dire l'oscillateur 101, et la phase d'un signal d'horloge délivré par un des oscillateurs commandés d'un des noeuds voisins.

Le nombre de comparateurs de phases que comporte chaque PLL est fonction de son emplacement dans le dispositif 1000. Ainsi, la PLL peut comporter deux comparateurs de phases 102 lorsque le noeud 103 de la PLL est disposé dans un coin du dispositif 1000 en forme de grille. La PLL peut comporter trois comparateurs de phases 102 lorsque le noeud 103 de la PLL est disposé au niveau d'un bord du dispositif 1000 en forme de grille. Enfin, la PLL peut comporter quatre comparateurs de phases lorsque la PLL se trouve à l'intérieur du dispositif 1000, c'est-à-dire entre les bords de la grille. Dans une variante, il est également possible que chaque PLL comporte plus de quatre comparateurs de phases, par exemple lorsque le dispositif de génération de signaux d'horloge n'est pas réalisé sous la forme d'une grille en deux dimensions, mais par exemple sous la forme d'un motif en trois dimensions, ou sous la forme d'une grille en deux dimensions comportant des connexions orientées dans plus de deux directions cartésiennes, formant par exemple une étoile.

Sur l'exemple de la figure 4, la PLL 100 comporte quatre comparateurs de phases 102.1 - 102.4.

Chacun des comparateurs de phases 102.1 - 102.4 comporte une première entrée 104.1 - 104.4 reliée à une sortie 106 de l'oscillateur commandé 101 de la PLL 100. De plus, chacun des comparateurs de phases 102.1 - 102.4 comporte une seconde entrée 108.1 - 108.4 chacune reliée à une sortie de l'oscillateur commandé de chacune des PLL voisines de la PLL 100.

Chaque erreur de phase calculée par les comparateurs de phases 102.1 - 102.4 est ensuite sommée dans des moyens de sommation pondérée 110, formant un additionneur pondéré, qui réalise une somme pondérée de ces erreurs de phase. De plus, bien que cela ne soit pas représenté sur la figure 4, les sorties de chacun des comparateurs de phases 102.1 - 102.4 sont également envoyées aux entrées respectives des moyens de sommation pondérée des PLL voisines (une inversion du signe des erreurs de phase étant préalablement réalisée avant l'entrée dans ces moyens de sommation pondérée). La somme pondérée obtenue en sortie des moyens 110 est ensuite envoyée dans un filtre passe-bas 112 qui fournie en sortie une commande régulant la fréquence de l'oscillateur commandé local 101. La sortie 106 de l'oscillateur commandé 101 forme la sortie de la PLL 100 sur laquelle est délivré le signal d'horloge qui est utilisé pour corriger les signaux d'horloge des autres PLL voisines du dispositif 1000.

Les moyens de sommation pondérée 110 sont ici tels qu'un des coefficients de pondération appliqué à un des signaux de sortie des comparateurs de phases 102.1 - 102.4, par exemple celui du comparateur de phases 102.1, ait une valeur absolue, appelée $n_j$, supérieure à la somme des valeurs absolues des autres coefficients de pondération, appelées $n_i$, avec $i \neq j$, appliqués aux autres signaux de sortie des comparateurs de phases 102.1 - 102.4, telle que :

$$n_j > \sum_{i \neq j} n_i$$

Dans une variante de réalisation, il est possible que la somme pondérée soit réalisée pour donner un poids plus important à plusieurs des signaux d'horloge appliqués en entrées de la PLL 100. Dans ce cas, les coefficients de pondération sont choisis tels que la somme des valeurs absolues des coefficients de pondération appliqués à une partie des signaux de sortie des comparateurs de phases 102.1 - 102.4, appelés coefficients de poids fort, soit supérieure à la somme des valeurs absolues des autres coefficients de pondération, appelés coefficients de poids faible, appliqués aux autres signaux de sortie des comparateurs de phases 102.1 - 102.4. Ces coefficients de poids fort compensent alors les coefficients de poids faible.

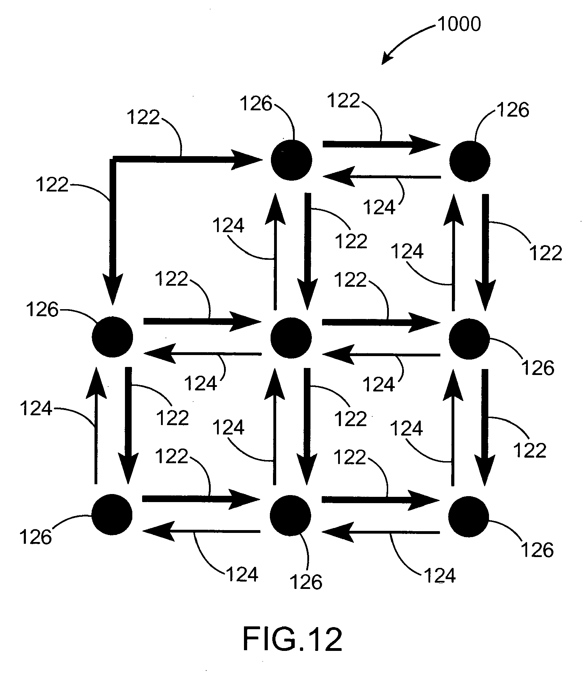

Dans cette variante de réalisation, les coefficients de pondération sont choisis tels que les signaux d'horloge, délivrés en sorties des boucles à phase asservie voisines et dont les phases comparées à la phase du signal d'horloge délivré par l'oscillateur commandé correspondent auxdits signaux de sortie auxquels sont appliqués les coefficients de pondération dont la somme des valeurs absolues est supérieure à la somme des valeurs absolues des autres coefficients de pondération, se propagent dans le réseau distribué de boucles à phase asservie sans former de boucle fermée. Un exemple d'une telle configuration est représentée sur la figure 12. Sur cette figure, une partie seulement du dispositif 1000 est représentée. Les flèches 122 représentent les signaux d'horloge dont les phases comparées à la phase du signal d'horloge délivré par l'oscillateur commandé correspondent auxdits signaux de sortie auxquels sont appliqués les coefficients de poids fort, tandis que les flèches 124 représentent les signaux d'horloge dont les phases comparées à la phase du signal d'horloge délivré par l'oscillateur commandé correspondent aux signaux de sortie auxquels sont appliqués les coefficients de pondération de poids faible. Ces signaux d'horloges se propagent à travers les PLL, référencées 126, du dispositif 1000. On voit sur la figure 12 que les signaux d'horloge correspondant aux flèches 122 se propagent dans le réseau de PLL 126 sans former de boucle fermée, c'est-à-dire ne reviennent pas dans une PLL à partir de laquelle ils ont été émis en sortie. Les trajets de propagation définis par ces coefficients de poids forts ne forment pas de boucle fermée.

Dans une autre variante, il est possible que les flèches 122 représentent les signaux d'horloge dont les phases comparées à la phase du signal d'horloge délivré par l'oscillateur commandé correspondent aux signaux de sortie auxquels sont appliqués les coefficients de poids faible, tandis que les flèches 124 représentent les signaux d'horloge dont les phases comparées à la phase du signal d'horloge délivré par l'oscillateur commandé correspondent aux signaux de sortie auxquels sont appliqués les coefficients de pondération de poids fort. Dans ce cas, les trajets de propagation définis par ces coefficients de poids forts ne forment pas non plus de boucle fermée. D'autres configurations sont également possibles.

Selon cette variante de réalisation, dans chaque boucle à phase asservie du dispositif 1000, en notant $n_j$ les valeurs absolues des coefficients de poids fort et $n_i$ les valeurs absolues des coefficients de poids faible, on a :

$$\sum n_j > \sum_{i \neq j} n_i$$

Les comparateurs de phases 102.1 - 102.4 sont ici de type bang-bang. Chacun de ces comparateurs de phases 102.1 - 102.4 génère en sortie un signal sur 1 bit représentatif du signe du déphasage entre les signaux d'horloge appliqués sur les deux entrées 104.1 - 104.4 et 108.1 - 108.4 de ces comparateurs de phases 102.1 - 102.4, c'est-à-dire entre un signal d'horloge de référence provenant de l'une des PLL voisines et le signal d'horloge issu de l'oscillateur commandé local 101 de la PLL 100. La réponse d'un comparateur de phases de type bang-bang est représentée sur la figure 5. Chacun des comparateurs de phases 102.1 - 102.4 délivre en sortie un signal égal à +1 ou à -1 lorsque le signal d'horloge de référence (provenant d'une PLL voisine) est respectivement en avance ou en retard sur le signal d'horloge local (provenant de la sortie 106 de l'oscillateur commandé local 101). Etant donné que les signaux de sortie des comparateurs de phases 102.1 - 102.4 sont codés sur 1 bit, ces signaux sont facilement pondérables avec des coefficients appropriés appliqués par les moyens 110, permettant de réaliser un changement automatique de mode de fonctionnement de la PLL 100 comme expliqué précédemment. De plus, dans cet exemple de réalisation, les éléments de la PLL 100, c'est-à-dire les comparateurs de phases 102.1 - 102.4, les moyens de sommation pondérée 110, le filtre 112 et l'oscillateur commandé 101, sont de type numérique, formant ainsi une PLL 100 numérique.

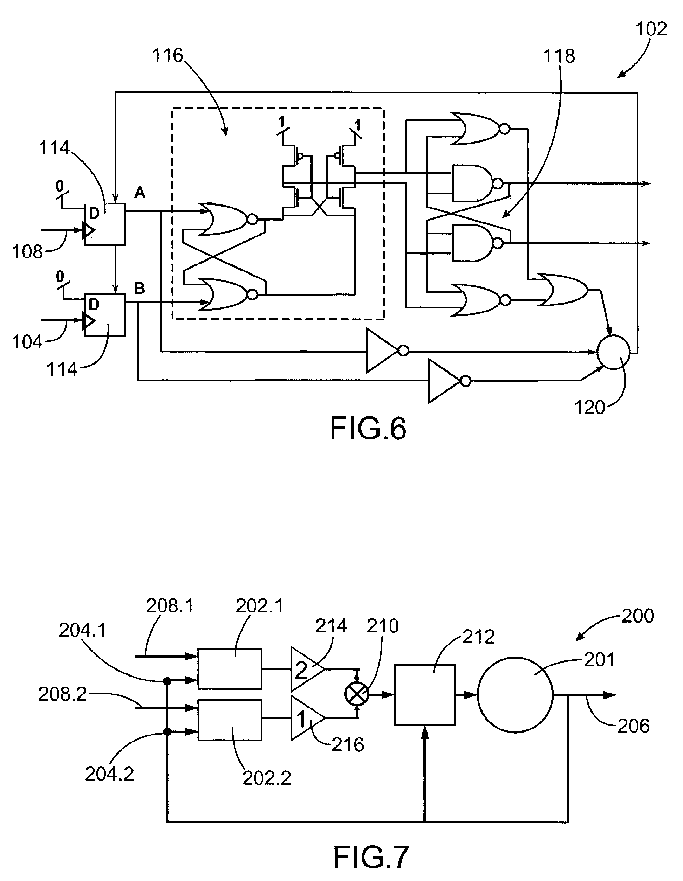

Un exemple de schéma de réalisation d'un comparateur de phases 102 de type bang-bang est représenté sur la figure 6. Ce comparateur de phases 102 comporte une première entrée 104 sur laquelle est appliqué le signal d'horloge de l'oscillateur local et une seconde entrée 108 sur laquelle est appliqué le signal d'horloge de référence (provenant d'une PLL voisine). Chacun de ces deux signaux d'horloge est envoyé en entrée de l'une de deux bascules D 114 permettant de détecter l'arrivée d'un front dans les signaux d'horloge appliqués sur les entrées 104 et 108. Le comparateur de phases 102 comporte en outre un élément d'exclusion mutuelle 116 permettant de déterminer lequel des deux fronts des signaux d'horloge est arrivé en premier en ignorant la situation de métastabilité (cas où deux horloges arrivent en même temps ou presque en même temps), réalisant ainsi une comparaison des phases des deux signaux d'horloge. Le résultat de cette comparaison est stocké dans une bascule R-S 118 dont la sortie forme la sortie du détecteur de phase 102. Un élément de type C Muller 120 permet, avec des éléments logiques appropriés, de remettre à zéro les bascules 114 afin qu'elles puissent détecter des nouveaux fronts des signaux d'horloge. D'autres détails relatifs à un tel comparateur de phases sont décrits dans le document « A Wide Power Supply Range, Wide Tuning Range, All Static CMOS All Digital PLL in 65 nm SOI » de J.A. Tierno et al., IEEE Journal of Solid-State Circuits, vol. 43, n°1, Janvier 2008.

Dans une variante de réalisation, il est possible que les PLL du dispositif 100 comportent des comparateurs de phases délivrant des signaux de sortie sur plusieurs bits. En effet, les comparateurs de phases de type bang-bang, lorsque le dispositif 1000 fonctionne en régime permanent, peuvent provoquer des oscillations. En effet, compte tenu de la nature de ce type de comparateur à 1 bit, pour des erreurs de phases proches de zéro (c'est-à-dire lorsque le dispositif 1000 est en régime synchronisé), les sorties des comparateurs de phases bang-bang peuvent osciller entre +1 et -1 de manière aléatoire avec une moyenne égale à zéro. Ces oscillations dont les valeurs sont fonction du filtre choisi peuvent provoquer des oscillations d'amplitude plus ou moins importantes de la fréquence du signal issu de l'oscillateur local et par conséquent, affecter la précision de la synchronisation de la PLL.

Une première solution peut consister à diminuer le gain statique du filtre utilisé dans les PLL, afin de diminuer ces oscillations fréquentielles du signal délivré par l'oscillateur local. Cette première solution a toutefois pour inconvénient de réduire la vitesse de convergence de la PLL en régime synchronisé, augmentant ainsi le temps de synchronisation nécessaire au dispositif 1000.

Une autre solution peut consister à utiliser des comparateurs de phases délivrant un signal de sortie sur plusieurs bits, fournissant une erreur de phases codée sur n bits, avec n nombre entier strictement supérieur à 1. Ainsi, notamment pour les erreurs de phases importantes, la sortie des comparateurs de phases peut avoir une valeur importante forçant la convergence rapide du dispositif 1000 vers la synchronisation, alors que pour les erreurs de phases faibles, lorsque le dispositif 1000 est en régime permanent, la sortie des comparateurs de phases oscille toujours mais avec une amplitude relative plus faible, réduisant son impact sur l'oscillation de fréquence de la PLL et donc sur sa précision. De tels comparateurs de phases peuvent délivrer sur leur sortie un signal symétrique ou non autour de 0. Les documents "Design and VHDL Modeling of All-Digital PLLs" de E. Zianbetov et al., 8th IEEE International NEWCAS Conference (NEWCAS'10), Montreal, Canada, 20-23 juin 2010, et "A high-resolution Flash time-to-digital converter and calibration scheme » de P. M. Levine et al., Test Conference, 2004. Proceedings. ITC 2004. International, 26-28 octobre 2004, pages 1148 - 1157, décrivent les éléments permettant la réalisation d'un comparateur de phases sur n bits.

Lorsque les PLL comportent de tels comparateurs de phases sur n bits, et que l'on souhaite que, dans chaque PLL, un des signaux d'horloge reçus en entrées soit prépondérant sur les autres, le coefficient de pondération de valeur absolue $n_j$ appliqué pour le signal d'horloge prépondérant est alors choisi tel que :

$$n_j > \frac{K}{k} \sum_{i \neq j} n_i$$

avec K : valeur maximale de la valeur absolue de la sortie du comparateur de phases ;
k : valeur minimale de la valeur absolue de la sortie du comparateur de phases.

On garantit ainsi un changement automatique de mode de propagation de l'information de phase dans le dispositif 1000.

Lorsque les PLL comportent des comparateurs de phases sur n bits, et que l'on souhaite que, dans chaque PLL, la somme pondérée permette de donner un poids plus important à plusieurs des signaux d'horloge appliqués en entrées d'une PLL, les coefficients de pondération sont choisis tels que :

$$\sum n_j > \frac{K}{k} \sum_{i \neq j} n_i$$

Avec $n_j$ : valeurs absolues des coefficients de poids fort ;
$n_i$ : valeurs absolues des coefficients de poids faible.

On décrit maintenant, en liaison avec la figure 7, le fonctionnement d'une PLL 200 comportant, de manière analogue à la PLL 100, un oscillateur commandé 201, des comparateurs de phases 202.1 et 202.2, des moyens de sommation pondérée formés par un additionneur 210 et des amplificateurs 214 et 216 de gains différents, ainsi qu'un filtre passe-bas 212. Cette PLL 200 ne comporte que deux comparateurs de phases 202.1 et 202.2 car elle est disposée, dans le dispositif 1000, dans un des coins du réseau et n'est donc reliée qu'à deux autres PLL voisines. La pondération des erreurs de phase obtenues en sortie des comparateurs de phases 202.1 et 202.2 est réalisée par un premier amplificateur 214 de gain égal à 2 et par un second multiplicateur 216 de gain unitaire. L'additionneur 210 additionne donc les erreurs de phase pondérées obtenues en sortie des amplificateurs 214 et 216.

Compte tenu des gains différents des amplificateurs 214 et 216, on réalise donc une comparaison asymétrique des erreurs de phase délivrées par les comparateurs de phases 202.1 et 202.2. Sur l'exemple de la figure 7, compte tenu du gain égal à 2 de l'amplificateur 214 par rapport au gain unitaire de l'amplificateur 216, on privilégie donc l'erreur de phase délivrée par le comparateur de phases 202.1. Si la PLL 200 comportait plus de deux comparateurs de phases, par exemple trois ou quatre, il serait possible de privilégier l'erreur de phase délivrée par un ou plusieurs comparateurs de phases en leur attribuant des amplificateurs de gains supérieurs à la somme des gains des autres amplificateurs recevant en entrée le signal de comparaison des autres comparateurs de phases, cette somme des gains des autres amplificateurs recevant en entrée le signal de comparaison des autres comparateurs de phases pouvant être multipliée par le facteur K/k comme dans les exemples précédents.

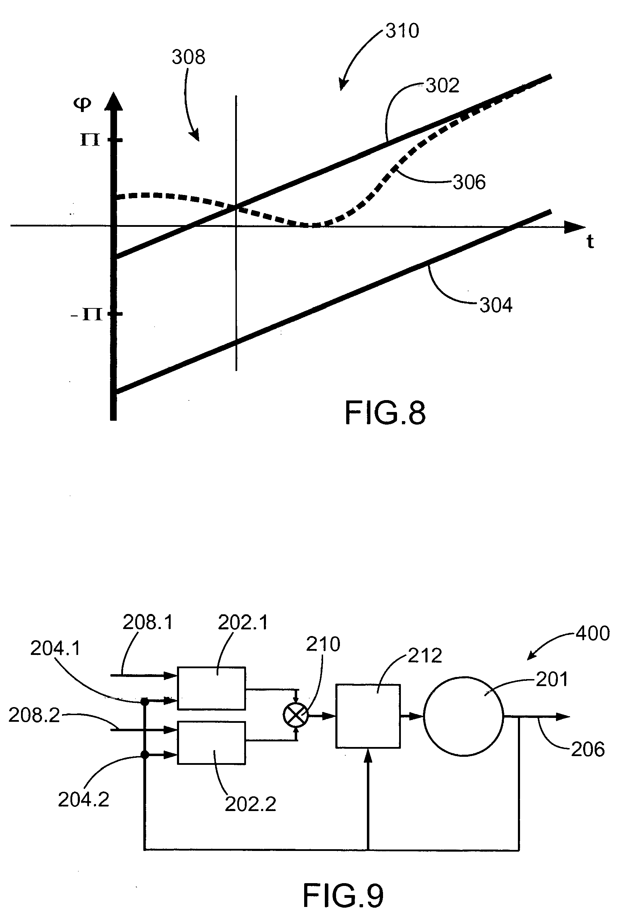

La correction de phase réalisée par cette PLL 200 est illustrée par les courbes représentées sur la figure 8. La droite 302 représente la phase d'une des deux PLL voisines appliquée en entrée du comparateur de phases 202.1 et la droite 304 représente la phase de l'autre des deux PLL voisines appliquée en entrée du comparateur de phases 202.2. La courbe 306 représente la phase du signal de sortie de l'oscillateur local 201. Au cours d'une première période 308, les erreurs de phase détectées par les deux comparateurs de phases 202.1 et 202.2 sont négatives. Un signal de correction égal à -3 est donc appliqué en entrée du filtre passe-bas 212 au cours de cette première période 308, ce qui entraine une réduction de la fréquence de l'oscillateur local 201. Lorsque la phase du signal de sortie de l'oscillateur local 201 se retrouve entre les phases des deux PLL voisines (période référencée 310 sur la figure 7, dans laquelle la courbe 306 se trouve entre les droites 302 et 304), la PLL 200 change alors de régime de fonctionnement. En effet, étant donné que le signal en sortie du comparateur de phases 202.1 n'est plus égal à -1 mais à +1, le signal de correction devient alors égal à +1, ce qui revient à ne considérer que l'erreur de phase provenant du comparateur de phases 202.1. On a alors la fréquence de l'oscillateur local 201 qui augmente. Le régime de propagation de l'information de phase devient unidirectionnel (sans boucles fermées), ce qui permet d'éviter de placer la PLL 200 dans un mode parasite. De plus, on voit que ce changement de régime se produit de manière automatique. Ainsi, la phase de l'oscillateur commandé local 201 va suivre celle représentée par la droite 302.

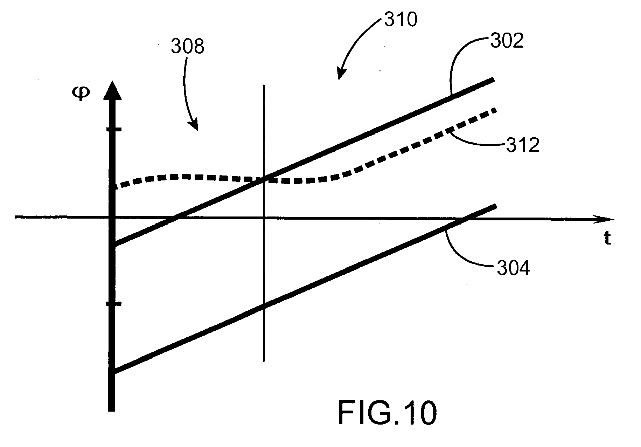

Par comparaison, dans le cas d'une PLL 400 (représentée sur la figure 9) ne réalisant pas une comparaison asymétrique des erreurs de phase et qui comporte les mêmes éléments que la PLL 200 excepté les amplificateurs 214 et 216, on représente sur la figure 10 les droites 302 et 304 similaires à celles de la figure 8 ainsi qu'une courbe 312 représentant la phase du signal de sortie de l'oscillateur local 201 de la PLL 400. Au cours de la première période 308, lorsque la phase du signal de sortie de l'oscillateur local 201 de la PLL 400 est supérieure aux erreurs de phase des deux PLL voisines, le signal de correction appliqué en entrée du filtre passe-bas 212 est égal à -2, ce qui provoque la diminution de la fréquence de l'oscillateur local 201 de la PLL 400. Lorsque la phase du signal de sortie de l'oscillateur local 201 de la PLL 400 passe entre les phases des deux PLL voisines, le coefficient de correction devient alors égal à 0. Ainsi, la phase ne change plus et continue de croître avec la fréquence nominale de l'oscillateur 201 de la PLL 400. On voit donc que la PLL 400 est bloquée dans un mode parasite et que les erreurs de phase ne sont plus corrigées.

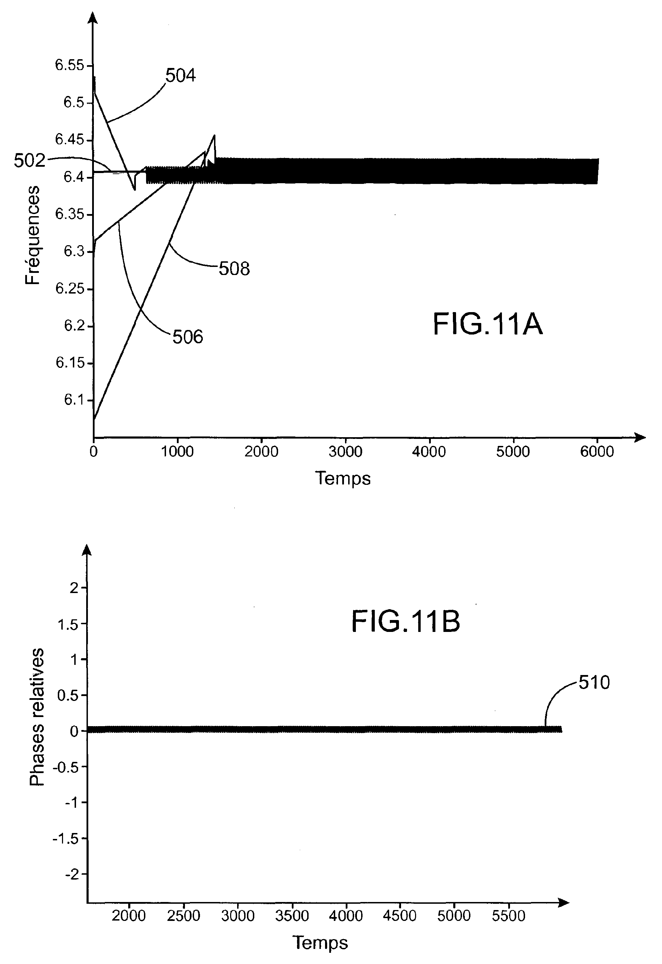

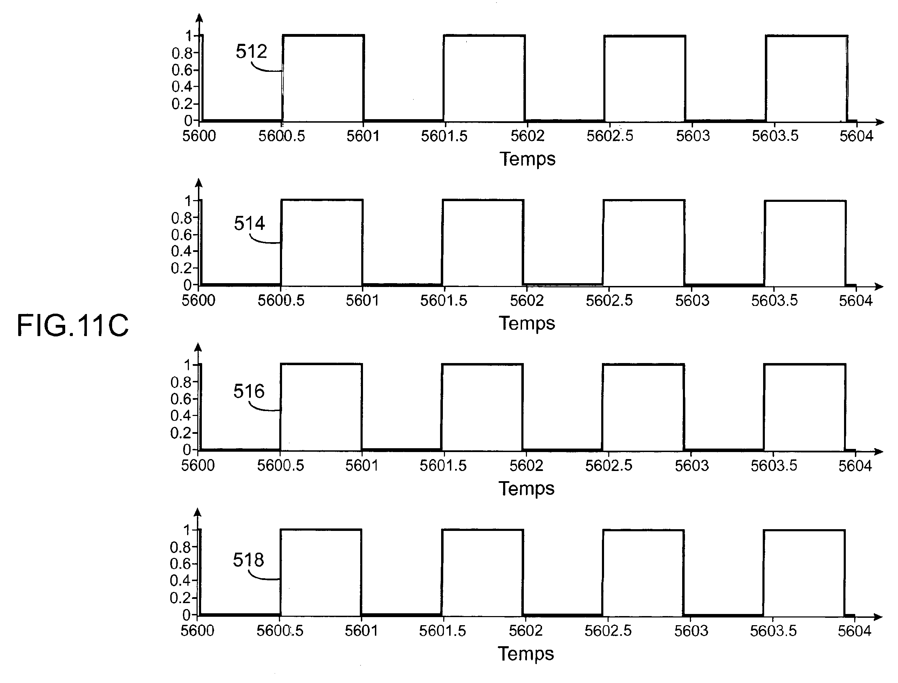

On se réfère maintenant aux figures 11A, 11B et 11C qui représentent des résultats de simulation de trois PLL du dispositif 1000.

Les courbes 504, 506 et 508 représentées sur la figure 11A correspondent aux fréquences de signaux d'horloge obtenus en sortie de trois PLL du dispositif 1000. La droite 502 représente le signal d'horloge de référence appliqué au niveau du noeud 105 du dispositif 1000. On voit sur cette figure 11A que les trois courbes 504, 506 et 508 rejoignent rapidement la courbe 502. On observe également qu'après avoir atteint la valeur de la droite 502, ces trois courbes oscillent autour de la valeur de la droite 502. Ces oscillations sont dues à la nature des comparateurs de phases de type bang-bang fonctionnant en régime synchronisé des PLL du dispositif 1000. Il est possible de diminuer ou même supprimer ces oscillations en concevant le dispositif 1000 tel qu'il soit possible de moduler les valeurs des coefficients de pondération appliqués aux différentes comparaisons de phases réalisées par les PLL du dispositif 1000. Il est par exemple possible de concevoir des PLL comportant des amplificateurs de gain variable dont les valeurs seraient choisies en fonction de l'état du dispositif 1000 (état stable ou non). Il est également possible d'utiliser les comparateurs de phases réalisant une comparaison asymétrique, c'est-à-dire une comparaison à réponse linéaire lorsque le résultat de la comparaison est proche de zéro et une comparaison « bang-bang » lorsque le résultat de la comparaison est éloigné de zéro.

Sur la figure 11B, on trace les valeurs des phases relatives des signaux d'horloge obtenus en sortie des trois PLL du dispositif 1000 lorsque le dispositif 1000 a atteint son état stable. On voit sur cette figure 11B que les valeurs des phases des signaux d'horloge de ces trois PLL sont sensiblement constantes et forment une droite 510 de valeur sensiblement égale à 0. On voit donc que les trois PLL ne présentent aucune erreur de phase par rapport au signal d'horloge maître du dispositif 1000.

Enfin, sur la figure 11C, on représente le signal d'horloge maître 512 ainsi que les signaux d'horloge 514, 516 et 518 obtenus en sortie des trois PLL lorsque le dispositif 1000 a atteint sont état stable. On voit clairement sur cette figure que les signaux d'horloge obtenus en sortie des trois PLL sont parfaitement synchronisés avec le signal d'horloge maître, aussi bien en phase qu'en fréquence.

**Revendications**

1. Dispositif (1000) de génération d'au moins un signal d'horloge, comportant un réseau distribué de boucles à phase asservie interconnectées et synchronisées les unes aux autres, chaque boucle à phase asservie (100, 200) comprenant :

   - un oscillateur commandé (101, 201) apte à délivrer en sortie (106, 206) le signal d'horloge,
   - une pluralité de comparateurs de phases (102, 102.1-102.4, 202.1-202.2) aptes à comparer une phase du signal d'horloge délivré par l'oscillateur commandé (101, 201) avec une pluralité de phases de signaux d'horloge délivrés en sorties des boucles à phase asservie voisines et appliqués en entrées de la boucle à phase asservie (100, 200),
- des moyens (110, 210, 214, 216) de sommation pondérée de signaux de sortie de la pluralité de comparateurs de phases (102, 102.1-102.4, 202.1-202.2) tels qu'un des coefficients de pondération appliqué à un desdits signaux de sortie ait une valeur absolue supérieure à la somme des valeurs absolues des autres coefficients de pondération appliqués aux autres signaux de sortie et/ou tels que la somme des valeurs absolues des coefficients de pondération appliqués à une partie desdits signaux de sortie soit supérieure à la somme des valeurs absolues des autres coefficients de pondération appliqués aux autres signaux de sortie,
- des moyens de filtrage (112, 212) de la somme pondérée des signaux de sortie de la pluralité de comparateurs de phases (102, 102.1-102.4, 202.1-202.2), aptes à délivrer en sortie un signal de commande à l'oscillateur commandé (101, 201),
et dans lequel, lorsque la somme des valeurs absolues des coefficients de pondération appliqués à une partie desdits signaux de sortie est supérieure à la somme des valeurs absolues des autres coefficients de pondération appliqués aux autres signaux de sortie, les signaux d'horloge, délivrés en sorties des boucles à phase asservie voisines et dont les phases comparées à la phase du signal d'horloge délivré par l'oscillateur commandé (101, 201) correspondent auxdits signaux de sortie auxquels sont appliqués les coefficients de pondération dont la somme des valeurs absolues est supérieure à la somme des valeurs absolues des autres coefficients de pondération, se propagent dans le réseau distribué de boucles à phase asservie sans former de boucle fermée.

2. Dispositif (1000) selon la revendication 1, chaque boucle à phase asservie (100, 200) comportant deux, trois ou quatre comparateurs de phases (102, 102.1-102.4, 202.1-202.2) aptes à comparer une phase du signal d'horloge délivré par l'oscillateur commandé (101, 201) avec les phases des signaux d'horloge appliqués en entrée de la boucle à phase asservie (100, 200).

3. Dispositif (1000) selon l'une des revendications précédentes, dans lequel chaque comparateur de phases (102, 102.1-102.4, 202.1-202.2) est apte à délivrer en sortie un signal codé sur 1 bit représentatif du signe de la comparaison destinée à être réalisée par le comparateur de phases (102, 102.1-102.4, 202.1-202.2) entre la phase du signal d'horloge délivré par l'oscillateur commandé (101, 201) et la phase d'un des signaux d'horloge appliqués en entrée de la boucle à phase asservie (100, 200).

4. Dispositif (1000) selon l'une des revendications 1 ou 2, dans lequel chaque comparateur de phases (102, 102.1-102.4, 202.1-202.2) est apte à délivrer en sortie un signal codé sur plusieurs bits représentant le signe et la valeur absolue de la comparaison destinée à être réalisée par le comparateur de phases (102, 102.1-102.4, 202.1-202.2) entre la phase du signal d'horloge délivré par l'oscillateur commandé (101, 201) et la phase d'un des signaux d'horloge appliqués en entrée de la boucle à phase asservie (100, 200).

5. Dispositif (1000) selon la revendication 4, dans lequel la valeur absolue $n_j$ dudit un des coefficients de pondération appliqué à un desdits signaux de sortie qui est supérieure à la somme des valeurs absolues ni des autres coefficients de pondération appliqués aux autres signaux de sortie est telle que :

$$n_j > \frac{K}{k}\sum_{i \neq j} n_i \ ,$$

avec

K : valeur maximale de la valeur absolue de la sortie d'un des comparateurs de phases ;
k : valeur minimale de la valeur absolue de la sortie d'un des comparateurs de phases.

6. Dispositif (1000) selon la revendication 4, dans lequel, lorsque la somme des valeurs absolues $n_j$ des coefficients de pondération appliqués à une partie desdits signaux de sortie est supérieure à la somme des valeurs absolues ni des autres coefficients de pondération appliqués aux autres signaux de sortie, les valeurs absolues $n_j$ sont telles que :

$$\sum n_j > \frac{K}{k}\sum_{i \neq j} n_i \ ,$$

avec

K : valeur maximale de la valeur absolue de la sortie d'un des comparateurs de phases ;
k : valeur minimale de la valeur absolue de la sortie d'un des comparateurs de phases.

7. Dispositif (1000) selon l'une des revendications précédentes, dans lequel les moyens de filtrage (112, 212) comportent au moins un filtre passe-bas.

**8.** Dispositif (1000) selon l'une des revendications précédentes, dans lequel les coefficients de pondération des moyens de sommation pondérée (110, 210, 214, 216) ont chacun une valeur comprise entre au moins -4 et 4.

**9.** Dispositif (1000) selon l'une des revendications précédentes, dans lequel l'oscillateur commandé (101, 201) et/ou les comparateurs de phases (102, 102.1-102.4, 202.1-202.2) et/ou les moyens de sommation pondérée (110, 210, 214, 216) et/ou les moyens de filtrage (112, 212) sont de type numérique.

**10.** Dispositif (1000) selon l'une des revendications précédentes, dans lequel les boucles à phase asservie (100, 200) sont reliées entre elles sous la forme d'une grille.

**11.** Dispositif (1000) selon la revendication 10, comportant en outre au moins un générateur (105) d'un signal d'horloge de référence appliqué en entrée d'au moins une de la pluralité de boucles à phase asservie.

**12.** Dispositif électronique comportant une pluralité d'éléments électroniques synchronisés par des signaux d'horloge synchrones délivrés par les boucles à verrouillage de phase d'un dispositif (1000) selon l'une des revendications précédentes.

**Patentansprüche**

**1.** Vorrichtung (1000) zur Erzeugung zumindest eines Taktsignals, welche ein verteiltes Netzwerk von miteinander verknüpften und synchronisierten Phasenregelkreisen aufweist, wobei jeder Phasenregelkreis (100, 200) Folgendes aufweist:

- einen gesteuerten Oszillator (101, 201), welcher in der Lage ist, das Taktsignal auszugeben (106, 206);
- eine Vielzahl von Phasenvergleichern (102, 102.1-102.4, 202.1-202.2), welche in der Lage sind, eine Phase des von dem gesteuerten Oszillator (101, 201) gelieferten Taktsignals mit einer Vielzahl von Phasen der Taktsignale zu vergleichen, welche von benachbarten Phasenregelkreisen ausgegeben und an die Eingänge des Phasenregelkreises (100, 200) angelegt werden;
- Einrichtungen (110, 210, 214, 216) zur gewichteten Addition der Ausgangssignale der Vielzahl von Phasenvergleichern (102, 102.1-102.4, 202.1-202.2), so dass einer der Gewichtungskoeffizienten, welcher an eines der Ausgangssignale angelegt wird, einen Absolutwert höher als die Summe der Absolutwerte der anderen Gewichtungsfaktoren, welche an andere Ausgangssignale angelegt werden, aufweist, und/oder so dass die Summe der Absolutwerte der an einen Teil der Ausgangssignale angelegten Gewichtungskoeffizienten höher ist als die Summe der Absolutwerte anderer Gewichtungskoeffizienten, welche an andere Ausgangssignale angelegt werden;

- Filtereinrichtungen (112, 212) zum Filtern der gewichteten Summe der Ausgangssignale aus der Vielzahl von Phasenvergleichern (102, 102.1-102.4, 202.1-202.2), welche in der Lage sind, ein Steuersignal an den gesteuerten Oszillator (101, 201) auszugeben,

und in welchem, wenn die Summe der Absolutwerte der Gewichtungskoeffizienten, welche an einen Teil der Ausgangssignale angelegt werden, höher ist als die Summe der Absolutwerte anderer Gewichtungskoeffizienten, welche an andere Ausgangssignale angelegt werden, die Taktsignale, welche von den benachbarten Phasenregelkreisen ausgegeben werden und deren Phasen verglichen mit der Phase des von dem gesteuerten Oszillator (101, 201) gelieferten Taktsignals mit den Ausgangssignalen übereinstimmen, an welche die Gewichtungskoeffizienten angelegt werden, deren Summe der Absolutwerte höher ist als die Summe der Absolutwerte anderer Gewichtungskoeffizienten, sich in dem verteilten Netz der Phasenregelkreise verbreiten, ohne dass ein geschlossener Regelkreis gebildet wird.

**2.** Vorrichtung (1000) nach Anspruch 1, wobei jeder Phasenregelkreis (100, 200) zwei, drei oder vier Phasenvergleicher (102, 102.1-102.4, 202.1-202.2) aufweist, welche in der Lage sind, eine Phase des von dem gesteuerten Oszillator (101, 201) gelieferten Taktsignals mit den Phasen der Taktsignale zu vergleichen, welche an den Eingang des Phasenregelkreises (100, 200) angelegt werden.

**3.** Vorrichtung (1000) nach einem der vorhergehenden Ansprüche, in welcher jeder Phasenvergleicher (102, 102.1-102.4, 202.1-202.2) in der Lage ist, ein auf 1 Bit kodiertes Signal auszugeben, welches das Vorzeichen des Vergleichs darstellt, welcher von dem Phasenvergleicher (102, 102.1-102.4, 202.1-202.2) zwischen der Phase des Taktsignals, welches von dem gesteuerten Oszillator (101, 201) geliefert wird, und der Phase eines der Taktsignale, welche an den Eingang des Phasenregelkreises (100, 200) angelegt werden, durchgeführt werden soll.

**4.** Vorrichtung (1000) nach einem der Ansprüche 1 oder 2, in welcher jeder Phasenvergleicher (102, 102.1-102.4, 202.1-202.2) in der Lage ist, ein auf mehrere Bits kodiertes Signal auszugeben, welches das Vorzeichen und den Absolutwert des Vergleichs darstellt, welcher von dem Phasenvergleicher (102, 102.1-102.4, 202.1-202.2) zwischen der von dem gesteuerten Oszillator (101, 201) gelieferten Phase des Taktsignals und der Phase eines der Taktsignale, welche an den Eingang des Phasenregelkreises (100, 200) angelegt werden, durchgeführt werden soll.

5. Vorrichtung (1000) nach Anspruch 4, in welcher der Absolutwert $n_j$ eines der an eines der Ausgangssignale angelegten Gewichtungskoeffizienten, wobei der Absolutwert höher ist als die Summe der Absolutwerte $n_i$ anderer Gewichtungskoeffizienten, welche an andere Ausgangssignale angelegt werden, so ist, dass:

$$n_j > \frac{K}{k} \sum_{i \neq j} n_i \; ,$$

wobei

K der Maximalwert des Absolutwerts des Ausgangs eines der Phasenvergleicher ist; und
k der Minimalwert des Absolutwerts des Ausgangs eines der Phasenvergleicher ist.

6. Vorrichtung (1000) nach Anspruch 4, in welcher, wenn die Summe der Absolutwerte $n_j$ der an einen Teil der Ausgangssignale angelegten Gewichtungskoeffizienten höher ist als die Summe der Absolutwerte $n_i$ anderer an andere Ausgangssignale angelegter Gewichtungskoeffizienten, die Absolutwerte $n_j$ so sind, dass:

$$\sum n_j > \frac{K}{k} \sum_{i \neq j} n_i \; ,$$

wobei

K der Maximalwert des Absolutwerts des Ausgangs eines der Phasenvergleicher ist; und
k der Minimalwert des Absolutwerts des Ausgangs eines der Phasenvergleicher ist.

7. Vorrichtung (1000) nach einem der vorhergehenden Ansprüche, in welcher die Filtereinrichtungen (112, 212) mindestens ein Tiefpassfilter aufweisen.

8. Vorrichtung (1000) nach einem der vorhergehenden Ansprüche, in welcher die Gewichtungskoeffizienten der Einrichtungen zur gewichteten Addition (110, 210, 214, 216) jeweils einen Wert zumindest zwischen -4 und 4 haben.

9. Vorrichtung (1000) nach einem der vorhergehenden Ansprüche, in welcher der gesteuerte Oszillator (101, 201) und/oder die Phasenvergleicher (102, 102.1-102.4, 202.1-202.2) und/oder die Einrichtungen zur gewichteten Addition (110, 210, 214, 216) und/oder die Filtereinrichtungen (112, 212) von numerischer Art sind.

10. Vorrichtung (1000) nach einem der vorhergehenden Ansprüche, in welcher die Phasenregelkreise (100, 200) in Form eines Rasters miteinander verknüpft sind.

11. Vorrichtung (1000) nach Anspruch 10, welche darüber hinaus mindestens einen Generator (105) zur Erzeugung eines Referenz-Taktsignals aufweist, welches an den Eingang zumindest eines der Vielzahl von Phasenregelkreisen angelegt wird.

12. Elektronische Vorrichtung, welche eine Vielzahl elektronischer Elemente aufweist, welche mit Hilfe der synchronen Taktsignale, welche von den Phasenverriegelungsschleifen einer Vorrichtung (1000) gemäß einem der vorhergehenden Ansprüche geliefert werden, synchronisiert sind.

**Claims**

1. Device (1000) for generating at least one clock signal, including a distributed network of phase-locked loops which are interconnected and synchronised with one another, where each phase-locked loop (100, 200) includes:

- a controlled oscillator (101, 201) capable of delivering the clock signal at output (106, 206),
- a plurality of phase comparators (102, 102.1-102.4, 202.1-202.2) capable of comparing a phase of the clock signal delivered by the controlled oscillator (101, 201) with a plurality of clock signal phases delivered at outputs of the adjacent phase-locked loops, and applied at inputs of the phase-locked loop (100, 200),
- means (110, 210, 214, 216) for weighted summation of output signals of the plurality of phase comparators (102, 102.1-102.4, 202.1-202.2) such that one of the weighting coefficients applied to one of said output signals has an absolute value higher than the sum of the absolute values of the other weighting coefficients applied to the other output signals and/or such that the sum of the absolute values of the weighting coefficients applied to a part of said output signals is greater than the sum of the absolute values of the other weighting coefficients applied to the other output signals,

- means (112, 212) for filtering the weighted sum of the output signals of the plurality of phase comparators (102, 102.1-102.4, 202.1-202.2), able to deliver at output a control signal to the controlled oscillator (101, 201),

and in which, when the sum of the absolute values of the weighting coefficients applied to a part of said output signals is greater than the sum of the absolute values of the other weighting coefficients applied to the other output signals, the clock signals, delivered at the outputs of the adjacent phase-locked loops, and the phases of which compared to the phase of the clock signal delivered by the controlled oscillator (101, 201) correspond to said output signals to which are applied the weighting coefficients, the sum of the absolute values of which is greater than the sum of the absolute values of the other weighting coefficients, are propagated in the distributed network of phase-locked loops without forming a closed loop.

2. Device (1000) according to claim 1, where each phase-locked loop (100, 200) includes two, three or four phase comparators (102, 102.1-102.4, 202.1-202.2) able to compare a phase of the clock signal delivered by the controlled oscillator (101, 201) with the phases of the clock signals applied at the input of the phase-locked loop (100, 200).

3. Device (1000) according to one of the previous claims, in which each phase comparator (102, 102.1-102.4, 202.1-202.2) is capable of delivering at output a signal encoded on 1 bit representing the comparison sign which is to be made by the phase comparator (102, 102.1-102.4, 202.1-202.2) between the phase of the clock signal delivered by the controlled oscillator (101, 201) and the phase of one of the clock signals applied at the input of the phase-locked loop (100, 200).

4. Device (1000) according to one of the claims 1 or 2, in which each phase comparator (102, 102.1-102.4, 202.1-202.2) is capable of delivering at output a signal encoded on several bits representing the sign and the absolute value of the comparison which is to be made by the phase comparator (102, 102.1-102.4, 202.1-202.2) between the phase of the clock signal delivered by the controlled oscillator (101, 201) and the phase of one of the clock signals applied at the input of the phase-locked loop (100, 200).

5. Device (1000) according to claim 4, in which the absolute value $n_j$ of said one of the weighting coefficients applied to one of said output signals which is greater than the sum of the absolute values $n_i$ of the other weighting coefficients applied to the other output signals is such that:

$$n_j > \frac{K}{k} \sum_{i \neq j} n_i \,,$$

where

K: maximum value of the absolute value of the output of one of the phase comparators;
k: minimum value of the absolute value of the output of one of the phase comparators.

6. Device (1000) according to claim 4, in which, when the sum of the absolute values $n_j$ of the weighting coefficients applied to a part of said output signals is greater than the sum of the absolute values $n_i$ of the other weighting coefficients applied to the other output signals, the absolute values $n_j$ are such that:

$$\sum n_j > \frac{K}{k} \sum_{i \neq j} n_i \,,$$

where

K: maximum value of the absolute value of the output of one of the phase comparators;
k: minimum value of the absolute value of the output of one of the phase comparators.

7. Device (1000) according to one of the previous claims, in which the filtering means (112, 212) include at least one low-pass filter.

8. Device (1000) according to one of the previous claims, in which each of the weighting coefficients of the means of weighted summation (110, 210, 214, 216) has a value of between at least -4 and 4.

9. Device (1000) according to one of the previous claims, in which the controlled oscillator (101, 201) and/or the phase comparators (102, 102.1-102.4, 202.1-202.2) and/or the means of weighted summation (110, 210, 214, 216) and/or the filtering means (112, 212) are of the digital type.

10. Device (1000) according to one of the previous claims, in which the phase-locked loops (100, 200) are connected to one another in the form of a grid.

11. Device (1000) according to claim 10, also including at least one generator (105) of a reference clock signal applied at the input of at least one of the plurality of phase-locked loops.

12. Electronic device including a plurality of electronic elements synchronised by synchronous clock signals delivered by the phase-locked loops of a device (1000) according to one of the previous claims.

FIG.1

FIG.2

FIG.3

FIG.4

FIG.5

FIG.6

FIG.7

FIG.8

FIG.9

FIG.10

FIG.11A

FIG.11B

FIG.11C

FIG.12

## RÉFÉRENCES CITÉES DANS LA DESCRIPTION

**Documents brevets cités dans la description**

- WO 9213305 A

**Littérature non-brevet citée dans la description**

- **COLINET E et al.** H∞ loop shaping control for distributed PLL network. *RESEARCH IN MICROELECTRONICS AND ELECTRONICS,* 12 Juillet 2009, ISBN 978-1-4244-3733-7, 336-339
- **J.A. TIERNO et al.** A Wide Power Supply Range, Wide Tuning Range, All Static CMOS All Digital PLL in 65 nm SOI. *IEEE Journal of Solid-State Circuits,* Janvier 2008, vol. 43 (1
- **E. ZIANBETOV et al.** Design and VHDL Modeling of All-Digital PLLs. *8th IEEE International NEWCAS Conference (NEWCAS'10), Montreal, Canada,* 20 Juin 2010
- **P. M. LEVINE E.** A high-resolution Flash time-to-digital converter and calibration scheme. *Test Conference, 2004. Proceedings. ITC 2004. International,* 26 Octobre 2004, 1148-1157